# EUROPEAN PATENT APPLICATION

(11) **EP 4 492 472 A1**
(43) Date of publication of application: **15.01.2025**
(21) Application number: 23184764.1
(22) Date of filing: 11.07.2023
(51) Int. Cl.: H01L 29/16, H01L 29/417, H01L 29/423, H01L 29/45, H01L 29/786, H01L 29/735, H01L 29/78, H01L 29/861

(54) **DOPANT-FREE SEMICONDUCTOR DEVICE, METHOD OF MANUFACTURING, AND ELECTRICAL CIRCUIT ELEMENT**

(71) Applicant: III-V Technologies GmbH, 1010 Wien (AT)
(72) Inventor: TAVAKOLIMEHRJARDI, Mahdi, 1050 Wien (AT); AMIRMAZLAGHANI, Mina, 1050 Wien (AT); RAISSI, Farshid, 1050 Wien (AT)
(74) Representative: Glawe, Delfs, Moll

(57) **Abstract**

It is disclosed a dopant-free, also called dopingless, semiconductor device (10) comprising: an intrinsic semiconductor layer (12), a first contact (13) in contact with the semiconductor layer (12), the first contact (13) comprising a first metal layer configured to form an Ohmic contact with the semiconductor layer (12) and to provide the first contact (13) for the creation of an electron-accumulated region (130) in the semiconductor layer (12), a second contact (14) in contact with the semiconductor layer (12), the second contact (14) comprising a second metal layer configured to form an Ohmic contact with the semiconductor layer (12) and to provide the second contact (14) for the creation of a hole-accumulated region (140) in the semiconductor layer (12), wherein the first and second contacts are arranged adjacent to each other such that the electron-accumulated region (130) and the hole-accumulated region (140) form a pn-junction (150), and wherein the first metal layer and the second metal layer are electrically separated from each other. Furthermore, bipolar transistors, MOSFETs, IGBTs and integrated circuits therefrom are disclosed, using the same principle of inducing doped regions and creating pn-junctions, as well as a method of manufacturing a dopant-free semiconductor device (10)..

## Description

The invention relates to a dopant-free semiconductor device comprising an intrinsic semiconductor layer, a first contact for the creation of an electron-accumulated region in the semiconductor layer and a second contact for the creation of a hole-accumulated region in the semiconductor layer, to a method of manufacturing a dopant-free semiconductor device and to an electrical circuit element comprising a first and a second dopant-free semiconductor device.

As electronic applications are increasingly used in all kinds of technical fields, the demand for highly efficient and versatile semiconductor devices is growing. Doping of the used semiconductor material with n- and p-type impurities is regularly required for the fabrication of these devices and is typically an essential step for achieving the desired functionality, particularly in the manufacture of active elements such as diodes and transistors. Fabrication of such devices typically involves numerous doping steps, such as defining specific n- and p-doped regions in a semiconductor layer, defining source, drain, and other contact regions, and additional steps to combat short-channel effects, such as a lightly doped drain (LDD) step and halo doping.

In addition, doping semiconductor material, especially by ion implantation, regularly causes undesirable effects in the material, e.g. due to damage to the crystal, performance degradation of the device being built. For example, doping typically has a negative effect on the drift velocities of holes and electrons. Also, doped regions typically exhibit parasitic capacitances at their boundaries to other regions or when diffusing under other functional areas of the device being built.

Furthermore, the charge carrier concentration in doped n- and p-regions in a semiconductor material may be insufficient at a temperature close to absolute zero to the effect of charge carrier freeze out, such that proper operation of the device cannot be achieved at such a low temperature.

Against the background of the aforementioned problems, it is therefore an object of the present invention to provide an improved semiconductor device, in which in particular occurrence of these problems can be avoided or at least substantially reduced.

The solution according to the invention lies in the features of the independent claims. Advantageous further embodiments are subject of the dependent claims.

According to the invention a dopant-free semiconductor device is disclosed, comprising: an intrinsic semiconductor layer, a first contact in contact with the semiconductor layer, the first contact comprising a first metal layer configured to form an Ohmic contact with the semiconductor layer and to provide the first contact for the creation of an electron-accumulated region in the semiconductor layer, a second contact in contact with the semiconductor layer, the second contact comprising a second metal layer configured to form an Ohmic contact with the semiconductor layer and to provide the second contact for the creation of a hole-accumulated region in the semiconductor layer, wherein the first and second contacts are arranged adjacent to each other such that the electron-accumulated region and the hole-accumulated region form a pn-junction, and wherein the first metal layer and the second metal layer are electrically separated from each other.

The dopant-free semiconductor according to the invention is for example a pn-diode using an intrinsic semiconductor layer, in which the pn-junction is formed, with the first and second metal layers being in direct contact with the semiconductor layer, forming Ohmic contacts of the first and second contacts and providing a first contact for creation of an electron-accumulated region in the semiconductor layer and a second contact for creation of a hole-accumulated region in the semiconductor layer.

In the following, some expressions that are used within the context of the invention are explained first:
A "dopant-free" semiconductor device is a semiconductor device that has not been doped, for example during its fabrication.

An undoped and thus dopant-free semiconductor layer is an "intrinsic semiconductor layer".

An "Ohmic contact" describes an electrical contact between a metal and a semiconductor that has a linear current-voltage characteristic exhibiting a non-rectifying behavior of the electrical contact. The opposite, i.e. a rectifying contact, is called a "Schottky contact". To obtain an Ohmic contact that provides for the creation of an electron-accumulated region in an intrinsic semiconductor the work function of the metal Øₘ is to be less than the work function of the semiconductor Øₛ, such that the edge of the conduction band E_{c} of the semiconductor is to bend down towards its Fermi level E_{f}. In this manner electrons can migrate from the metal to the semiconductor such that, starting from the area of the contact, electrons accumulate in a defined region in the semiconductor, without having a voltage applied to the contact. To obtain an Ohmic contact that provides for the creation of a hole-accumulated region in an intrinsic semiconductor the work function of the metal Øₘ is to be larger than the work function of the semiconductor Øₛ, such that the edge of the valence band Eᵥ of the semiconductor bends up towards its Fermi level E_{f}. In this manner electrons can migrate from the semiconductor to the metal such that starting from the area of the contact, holes accumulate in a defined hole-accumulated region in the semiconductor, without having a voltage applied to the contact. The effect of conduction and valence band bending in terms of energy can be obtained by subtracting the semiconductor work function Øₛ from the work function of the metal Øₘ or vice versa and multiplying with the charge q. This is the voltage drop occurring inside the semiconductor, and a charge carrier density, i.e. electron or hole density, is accumulated in the respective regions. The amount of the charge carriers is exponentially related to the voltage drop. The effect of conduction and valence band bending can also be obtained, in lower strength, if a - sufficiently thin - insulation layer is arranged between the metal and the semiconductor. In this case, the charge carrier density is reduced compared to a direct metal-semiconductor contact. An effective current flow through the contact is then prevented by the insulating intermediate layer.

The first metal layer is to be configured to form an Ohmic contact with the semiconductor layer and to provide the creation of an electron-accumulated region in the semiconductor layer by the first contact, and the second metal layer is to be configured to form an Ohmic contact with the semiconductor layer and to provide the creation of a hole-accumulated region in the semiconductor layer by the second contact.

"Vertical" means a direction normal to a "horizontal" plane, which is spanned by the first and second contacts of the semiconductor device, for example taking into account their respective areal extensions, and in which is parallel to the direction of the current flow between the first and second contacts.

The invention relates to a particularly advantageous embodiment of a semiconductor device. The semiconductor device is free of dopants and comprises an intrinsic semiconductor layer, in which electrons and holes are induced by contacts. The contacts comprise metal layers for forming Ohmic contacts with the semiconductor layer, allowing to create electron- and hole-accumulated regions (corresponding to n- and p-regions) for obtaining nonlinear electronic elements such as diodes and transistors. That is, the arrangement of n- and p-regions can be defined by arrangement of the contacts. In particular, a first contact for the creation of an electron-accumulated region and a second contact for the creation of a hole-accumulated region may be arranged on the same side of the semiconductor layer. Each metal layer, e.g. first, second and third metal layers, may be directly in contact with the semiconductor layer.

For each contact, starting from the area of the contact, the respectively obtained n- and p-regions extend spatially into the semiconductor layer. Accordingly, the regions extend both vertically and horizontally, and in particular may extend horizontally beyond the edge of the respective contact. Thus, two contacts may be electrically separated, but the regions induced by them may be directly adjacent to each other. If this is the case for an electron-inducing first contact and a hole-inducing second contact, a pn-junction can be formed for the semiconductor device within its intrinsic semiconductor layer. By passing current from one contact to the other, the current-voltage characteristics of a regular pn-junction can be obtained.

The electron- and hole-accumulated regions are assumed to have been created when sufficient charge carriers are generated in the semiconductor layer for proper operation of the semiconductor device. The electron-accumulated regions are specified to extend from the area of the first contact into the semiconductor layer to a distance where the conduction band is bent down by at least 0.3 eV. The hole-accumulated regions are specified to extend from the area of the second contact into the semiconductor layer to a distance where the valence band is bent up by at least 0.3 eV. This results in a charge carrier density of 10¹⁵/cm³ in the respective regions, which is five orders of magnitude larger than the intrinsic value of electrons in the semiconductor layer at room temperature and is sufficient for proper operation of the semiconductor device. Proper operation of the semiconductor device may already be achieved with lower charge carrier densities. Theoretically any density above the intrinsic value would allow the formation of a pn-junction. In practical, carrier densities in the order of 10¹⁵/cm³ allow for proper semiconductor device operation, for which the valence band and the conduction band would not cross the Fermi level. The intrinsic semiconductor layer may for instance have a vertical thickness of 10 nm or less. Preferably, the electron-accumulated region and/or the hole-accumulated region may be created along the entire thickness of the semiconductor layer. This avoids undesirable effects in the operation of the semiconductor device due to parallel conduction paths for charge carriers in the semiconductor layer, in particular below the accumulation regions.

The inventive semiconductor device can be operated without having to implement doped regions. In particular, doping of the semiconductor layer can be avoided, so that corresponding processing steps are not required and the overall effort of manufacturing the semiconductor device can be reduced. Furthermore, undesirable effects induced by doping, e.g. due to damage to the crystal, can be dispensed with, such as a negative effect on the drift velocities of holes and electrons or parasitic capacitances between boundaries of doped regions. In addition, since the electron- and hole-accumulated regions are created by contacts and not by doping, a largely temperature-independent operation is possible. Since the semiconductor substrate is free of dopants, latch-up problems due to contacts between multiple n- and p-regions can be avoided, and otherwise necessary mitigation measures can be dispensed with. The inventive semiconductor device may for example be used as a solar cell element converting energy of light into electricity by absorbing light in the intrinsic semiconductor layer in a depletion region outside the electron- and hole-accumulated regions.

According to an embodiment of the dopant-free semiconductor device, in the electron-accumulated region the conduction band is below the Fermi level, and/or in the hole-accumulated region the valence band is above the Fermi level.

This could be accomplished for both electron- and hole-accumulated regions for example if the difference between the work functions of the metal and the semiconductor is more than half the semiconductor bandgap energy, which in case of Si is about 0.55 eV. In this way, the respective charge carrier densities in the electron- and hole-accumulated regions may reach an order of 10²¹/cm³, and furthermore the semiconductor device may operate substantially independent of a prevailing temperature. In particular, this allows the semiconductor device to be operated even at very low temperatures, for example close to absolute zero.

The semiconductor layer may be at least partially formed from an elemental semiconductor, for example Si. Intrinsic Si has a work function Øₛ of about 4.7 eV, therefore, metals with work functions smaller than this would be appropriate for forming an electron-accumulated Ohmic contact. Among such metals are Ti and Ag with work functions Øₘ of 4.33 eV and 4.26 eV, respectively. Appropriate metals for forming a hole-accumulated Ohmic contact on a Si semiconductor layer are Pd and Ni with work functions Øₘ of 5.12 eV and 5 eV, respectively. Accordingly, the first metal layer may be at least partially formed from Ti or Ag and/or the second metal layer may be at least partially formed from Pd or Ni.

Advantageously, the dopant-free semiconductor device may further comprise an insulating substrate in contact with the semiconductor layer. For example, the insulating substrate can be arranged on a side of the semiconductor layer facing away from the first and second contacts, in particular on the side opposite to the first and second contacts.

The application of an insulating substrate allows the semiconductor layer to be electrically shielded and deposited on top of it. This enables sufficiently practical handling of particularly thin semiconductor layers, for example with a thickness of 10 nm or less. For example, the semiconductor device may accordingly be embodied as an ultrathin silicon-on-insulator wafer comprising an intrinsic Si semiconductor layer, onto which the first and second contacts are placed.

In an embodiment, the dopant-free semiconductor device further comprises a third contact in contact with the semiconductor layer, the third contact comprising a third metal layer configured to form an Ohmic contact with the semiconductor layer and to provide the third contact for the creation of an electron-accumulated region in the semiconductor layer, wherein the second and third contacts are arranged adjacent to each other such that the electron-accumulated region created by the third contact and the hole-accumulated region form a pn-junction, wherein the third metal layer and the second metal layer are electrically separated from each other, wherein the first contact is configured as an emitter, wherein the second contact is configured as a base, wherein the third contact is configured as a collector, and wherein the second contact is arranged between the first contact and the third contact for controlling charge flow between emitter and collector.

In such an embodiment, the semiconductor device may provide the functionality of a npn bipolar junction transistor (BJT), with the third metal layer being configured to enable the third contact to create an electron-accumulated region in the semiconductor layer. In particular, the third metal layer may be formed of the same material as the first metal layer. The three contacts are arranged alternately in series, wherein emitter and collector, being first and third contacts, create electron-accumulated regions, while the base, being a second contact arranged between emitter and collector, creates a hole-accumulated region. The contacts are arranged adjacent to each other such the hole-accumulated region of the base forms a pn-junction with the electron-accumulated region of the emitter, and also forms a pn-junction with the electron-accumulated region of the collector. This allows for charge flow between emitter and collector to be controllable by the base, e.g. by modulating a voltage applied to the contact of the base.

In a further embodiment, the dopant-free semiconductor device comprises a third contact in contact with the semiconductor layer, the third contact comprising a third metal layer configured to form an Ohmic contact with the semiconductor layer and to provide the third contact for the creation of a hole-accumulated region in the semiconductor layer, wherein the second and third contacts are arranged adjacent to each other such that the hole-accumulated region created by the third contact and the electron-accumulated region form a pn-junction, wherein the third metal layer and the first metal layer are electrically separated from each other, wherein the second contact is configured as an emitter, wherein the first contact is configured as a base, wherein the third contact is configured as a collector, and wherein the first contact is arranged between the second contact and the third contact for controlling charge flow between emitter and collector.

In this embodiment the semiconductor device may correspondingly provide the functionality of a pnp BJT, with the third metal layer being configured to enable the third contact to create a hole-accumulated region in the semiconductor layer. In particular, the third metal layer may be formed of the same material as the second metal layer. Since BJTs of both types, i.e. npn and pnp, can be realized with the semiconductor device, it is possible to fabricate logic circuits based on accordingly configured semiconductor devices.

Additionally, the semiconductor device may comprise a fourth contact arranged between the emitter and the base and electrically separated from the emitter, wherein the fourth contact comprises a metal layer corresponding to the metal layer of the emitter and an insulating layer arranged between the semiconductor layer and the metal layer of the fourth contact. That is, the metal layer of the fourth contact may be formed corresponding to the first or the second metal layer.

In particular, the type of contact of the fourth contact, i.e. creating an electron-accumulated region or a hole-accumulated region in the semiconductor layer, corresponds to the type of contact of the emitter. This allows the charge carrier density accumulated in the semiconductor layer at the emitter-side of the semiconductor device, i.e. the respective BJT, to be modulated via an extra insulated contact. By applying a voltage to the emitter-like contact, the charge carrier density accumulated in the semiconductor layer at the emitter side of the semiconductor device may be increased/decreased and the current amplification factor may be increased/decreased.

Exemplarily, the base may be split into first and second sub-bases electrically separated from each other, wherein the sub-bases are arranged adjacent to each other in a direction perpendicular to the vertical directions and to the direction of the current flow between emitter and collector, and wherein the first subbase comprises an insulating layer between the semiconductor layer and the first metal layer or between the semiconductor layer and the second metal layer. This configuration is advantageous in that application of a voltage to the isolated metal contact changes both carrier density as well as the effective size of the base region, which can accordingly be decreased or increased and as a result a nonlinear relationship between current amplification factor and applied voltage can be obtained. This non-linearity is particularly advantageous in electrical applications such as mixing signals.

According to an embodiment, the dopant-free semiconductor device comprises a third contact in contact with the semiconductor layer, the third contact comprising a third metal layer configured to form an Ohmic contact with the semiconductor layer and to provide the third contact for the creation of an electron-accumulated region in the semiconductor layer, wherein the second and third contacts are arranged adjacent to each other such that the electron-accumulated region created by the third contact and the hole-accumulated region form a pn-junction, and wherein the third metal layer and the second metal layer are electrically separated from each other, wherein the first contact is configured as a source, wherein the second contact is configured as a gate comprising an insulating layer between the second metal layer and the semiconductor layer, wherein the third contact is configured as a drain, and wherein the second contact is arranged between the first contact and the third contact for controlling charge flow between source and drain.

In such an embodiment, the semiconductor device may provide the functionality of a n-channel metal-oxide-semiconductor field-effect transistor (MOSFET) with the third metal layer being configured to enable the third contact to create an electron-accumulated region in the semiconductor layer, and with the second contact being configured as an isolated gate connection for controlling the current-voltage characteristics. In particular, the third metal layer may be formed of the same material as the first metal layer. The three contacts are arranged alternately in series, wherein source and drain, being first and third contacts, create electron-accumulated regions, while the gate, being a second contact arranged between emitter and collector, creates a hole-accumulated region. The contacts are arranged adjacent to each other such that the hole-accumulated region of the gate forms a pn-junction with the electron-accumulated region of the source, and also forms a pn-junction with the electron-accumulated region of the drain. This allows for charge flow between source and drain to be controllable by the gate, e.g. by modulating a voltage applied to the contact of the gate.

According to a further embodiment, the dopant-free semiconductor device comprises a third contact in contact with the semiconductor layer, the third contact comprising a third metal layer configured to form an Ohmic contact with the semiconductor layer and to provide the third contact for the creation of a hole-accumulated region in the semiconductor layer, wherein the first and third contacts are arranged adjacent to each other such that the hole-accumulated region created by the third contact and the electron-accumulated region form a pn-junction, and wherein the third metal layer and the first metal layer are electrically separated from each other, wherein the second contact is configured as a source, wherein the first contact is configured as a gate comprising an insulating layer between the first metal layer and the semiconductor layer, wherein the third contact is configured as a drain, and wherein the first contact is arranged between the second contact and the third contact for controlling charge flow between source and drain.

In this embodiment the semiconductor device may correspondingly provide the functionality of a p-channel MOSFET, with the third metal layer being configured to enable the third contact to create a hole-accumulated region in the semiconductor layer, and - in this case - the first contact being configured as an isolated gate. In particular, the third metal layer may be formed of the same material as the second metal layer. Since MOSFETs of both types, i.e. n-channel and p-channel, can be realized with the semiconductor device, it is possible to fabricate logic circuits based on accordingly configured semiconductor devices.

Additionally, gate and drain may be separated from each other by a distance, which is larger than the thickness of the insulating layer.

The distance between the gate and drain contacts can be set in dependence of the thickness of the insulator. The distance between gate and drain can be for example of the same order of magnitude as the distance between the drain and source, for example at the nanoscale. Applying a drain voltage can cause negative effects, such as short channel effects, on the device characteristics, and in order to mitigate such effects, the drain contact may be separated from the gate contact by a distance that larger than the thickness of the insulating layer of the gate. Exemplarily, gate and drain may be separated from each other by a distance, which is twice or at least twice the thickness of the insulating layer. For example, the insulating layer may have a thickness of 10 nm while the distance between gate and drain may be 20 nm.

In an embodiment, the dopant-free semiconductor device comprises two first and two second contacts, wherein the first and second contacts are arranged alternately in series.

This allows to realize with the semiconductor device a thyristor, a semiconductor-controlled rectifier (SCR) or a Darlington connection.

Exemplarily, the semiconductor device may be free of further contacts.

This means that the semiconductor device only has those contacts described in the respective embodiments. In particular, no further contacts may need to be provided to achieve proper operation of the semiconductor device. The semiconductor device may be configured such that its proper operation can be accomplished using only the specified contacts, in particular in the specified number. It is also conceivable that the contacts, e.g. first, second and/or third contact, are each implemented as a single contact, and in particular are not divided into multiple subcontacts, for example of the same function. This enables a particularly simple implementation of the semiconductor device taking into account a very small number of contacts, for example in an integrated circuit. For this, for example, only two, three or at most four contacts may have to be considered.

In accordance with the invention, there is also disclosed a method of manufacturing a dopant-free semiconductor device according to the invention, comprising: providing an intrinsic semiconductor layer; providing a first contact onto the semiconductor layer comprising applying a first metal layer configured to form an Ohmic contact with the semiconductor layer and to provide the first contact for the creation of an electron-accumulated region in the semiconductor layer; and providing a second contact onto the semiconductor layer, comprising applying a second metal layer electrically separated from the first metal layer, configured to form an Ohmic contact with the semiconductor layer and to provide the second contact for the creation of a hole-accumulated region in the semiconductor layer, wherein the first and second contacts are arranged adjacent to each other such that the electron-accumulated region and the hole-accumulated region form a pn-junction.

For instance, the intrinsic semiconductor layer can be formed by Low Pressure Chemical Vapor Deposition (LPCVD) method where Silene gas is decomposed in an LPCVD system and is deposited, for example on an appropriate insulating substrate, such as a substrate of quartz glass, Alumina, or flexible material such as polyethylene terephthalate (PET). By proper temperature control the intrinsic semiconductor layer can be formed as a polysilicon layer.

The intrinsic semiconductor layer may for instance be a polysilicon layer, allowing the semiconductor device to achieve similar performance in terms of speed compared to doped single crystal Si devices by providing a sufficiently high charge carrier mobility. For an exemplary use of the semiconductor device as a solar cell element, the thickness of the intrinsic semiconductor layer can be chosen based on the absorption depth of sun light in Si. For example, and in particular for use of the semiconductor device as a solar cell element, the intrinsic semiconductor layer may be a polysilicon layer with a thickness of 1 µm. In another example, and in particular for use of the semiconductor device as a transistor element, such as a BJT or a MOSFET, the intrinsic semiconductor layer may be a polysilicon layer with a thickness of 10 nm.

The first and second contacts can be applied, e.g. subsequently, for example by defining via lithography, such as photolithography, x-ray lithography or electron beam lithography, and metal deposition via lift off method. One of the first and second metal layers creating either electron-accumulated or hole-accumulated region can be deposited and etched down to the semiconductor layer via lithography according to predetermined size and shape. The other of the first and second metal layers may be defined, e.g. by photolithography, and the metal be deposited, for example over the whole horizontal area of the semiconductor device, covering the already deposited metal layer as well as the intrinsic semiconductor layer. The metal layer deposited secondly may be etched away, e.g. in a dry or wet etching process, allowing to obtain a horizontal metal free area between first and metal layers, while the metal layer deposited firstly may remain covered with the metal layer deposited secondly without relevant functional impairment of the resulting semiconductor device.

For application of an insulating layer, such as for use of the semiconductor device as a MOSFET, an oxide layer may be grown over the intrinsic semiconductor layer, which may be formed as an intrinsic polysilicon layer, before the application of the contacts. For applying the contacts, the insulating layer is to be removed in the respective areas.

For a more detailed explanation of further advantageous embodiments of the method, reference is made to the embodiments of the semiconductor device described above. Likewise, the semiconductor device can be further developed with additional features described in the context of the method.

Furthermore, an electrical circuit element comprising a first dopant-free semiconductor device according to the invention and a second dopant-free semiconductor device according to the invention is disclosed, wherein the semiconductor layers of the first and second dopant-free semiconductor devices are formed of a single common semiconductor layer.

Such an electrical circuit element comprising a single intrinsic semiconductor layer may for instance be built on a common substrate and be compatible with current CMOS technology.

For example, the common semiconductor layer may comprise an insulating portion extending along the entire thickness of the common semiconductor layer for electrically separating the semiconductor layer of the first dopant-free semiconductor device from the semiconductor layer of the second dopant-free semiconductor device. This can avoid inadvertently creating a pn-junction between the first and second semiconductor devices.

In particular, the first dopant-free semiconductor device may be embodied comprising a third contact in contact with the semiconductor layer, the third contact comprising a third metal layer configured to form an Ohmic contact with the semiconductor layer and to provide the third contact for the creation of an electron-accumulated region in the semiconductor layer, wherein the second and third contacts are arranged adjacent to each other such that the electron-accumulated region created by the third contact and the hole-accumulated region form a pn-junction, wherein the third metal layer and the second metal layer are electrically separated from each other, wherein the first contact is configured as an emitter, wherein the second contact is configured as a base, wherein the third contact is configured as a collector, and wherein the second contact is arranged between the first contact and the third contact for controlling charge flow between emitter and collector, and the second dopant-free semiconductor device may be embodied comprising a third contact in contact with the semiconductor layer, the third contact comprising a third metal layer configured to form an Ohmic contact with the semiconductor layer and to provide the third contact for the creation of a hole-accumulated region in the semiconductor layer, wherein the second and third contacts are arranged adjacent to each other such that the hole-accumulated region created by the third contact and the electron-accumulated region form a pn-junction, wherein the third metal layer and the first metal layer are electrically separated from each other, wherein the second contact is configured as an emitter, wherein the first contact is configured as a base, wherein the third contact is configured as a collector, and wherein the first contact is arranged between the second contact and the third contact for controlling charge flow between emitter and collector.

Alternatively, the first dopant-free semiconductor device may be embodied comprising a third contact in contact with the semiconductor layer, the third contact comprising a third metal layer configured to form an Ohmic contact with the semiconductor layer and to provide the third contact for the creation of an electron-accumulated region in the semiconductor layer, wherein the second and third contacts are arranged adjacent to each other such that the electron-accumulated region created by the third contact and the hole-accumulated region form a pn-junction, wherein the third metal layer and the second metal layer are electrically separated from each other, wherein the first contact is configured as a source, wherein the second contact is configured as a gate comprising an insulating layer between the second metal layer and the semiconductor layer, wherein the third contact is configured as a drain, and wherein the second contact is arranged between the first contact and the third contact for controlling charge flow between source and drain, and the second dopant-free semiconductor device may be embodied comprising a third contact in contact with the semiconductor layer, the third contact comprising a third metal layer configured to form an Ohmic contact with the semiconductor layer and to provide the third contact for the creation of a hole-accumulated region in the semiconductor layer, wherein the first and third contacts are arranged adjacent to each other such that the hole-accumulated region created by the third contact and the electron-accumulated region form a pn-junction, wherein the third metal layer and the first metal layer are electrically separated from each other, wherein the second contact is configured as a source, wherein the first contact is configured as a gate comprising an insulating layer between the first metal layer and the semiconductor layer, wherein the third contact is configured as a drain, and wherein the first contact is arranged between the second contact and the third contact for controlling charge flow between source and drain.

Accordingly, the first dopant-free semiconductor device may be embodied as a npn BJT and the second dopant-free semiconductor device may be embodied as a pnp BJT. Alternatively, the first dopant-free semiconductor device may be embodied as a n-channel MOSFET and the second dopant-free semiconductor device may be embodied as a p-channel MOSFET.

With these configurations, different types of logical electrical circuit elements can be realized, for example in an according integrated circuit.

It is to be understood that the presentation of the invention in this section is merely by way of examples and non-limiting.

The invention is explained in more detail below by way of examples in conjunction with the accompanying drawings, showing advantageous embodiments.

In the figures show:
- Figures 1-5: schematic representations of embodiments of dopant-free semiconductor devices according to the invention;
- Figure 6: a schematic representation of an embodiment of an electric circuit element according to the invention;
- Figure 7: a schematic band diagram of an Ohmic contact with a semiconductor layer creating an electron-accumulated region; and
- Figure 8: a schematic band diagram of an Ohmic contact with a semiconductor layer creating a hole-accumulated region.

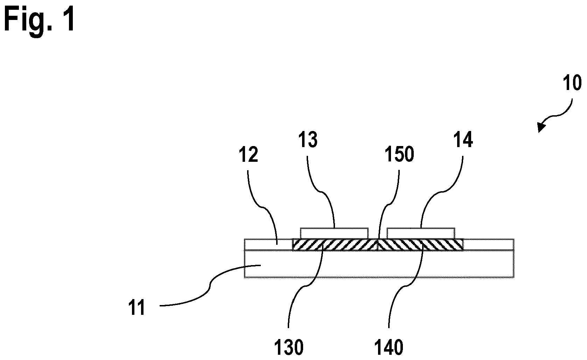

Each of Figs. 1-5 shows a schematic representation of an embodiment of a dopant-free semiconductor device 10 according to the invention, comprising an intrinsic semiconductor layer 12, a first contact 13 and a second contact 14, which are in contact with the semiconductor layer 12. The first and second contacts 13, 14 are arranged on the same side of the semiconductor layer 12. The semiconductor layer 12 is formed from intrinsic Si and has a vertical thickness of 10 nm.

The first contact 13 comprises a first metal layer configured to form an Ohmic contact with the semiconductor layer 12 providing the first contact 13 for the creation of an electron-accumulated region 130 in the semiconductor layer 12. Correspondingly, the second contact 14 comprises a second metal layer configured to form an Ohmic contact with the semiconductor layer 12 providing the second contact 14 for the creation of an hole-accumulated region 140 in the semiconductor layer 12. The first metal layer is formed from Ti and is electrically separated from the second metal layer, which is formed from Pd.

The electron-accumulated region 130 and the hole-accumulated region 140 are created along the entire thickness of the semiconductor layer 12. In the electron-accumulated region 130 the conduction band is below the Fermi level, and in the hole-accumulated region 140 the valence band is above the Fermi level. The respective charge carrier densities in the electron- and hole-accumulated regions 130, 140 reaches an order of 10²¹/cm³.

The created electron- and hole-accumulated regions 130, 140 respectively extend spatially into the semiconductor layer 12. Accordingly, the regions 130, 140 extend both vertically and horizontally, and in particular extend horizontally beyond the edge of the respective contact 13, 14. Thus, the first and second contacts 13, 14 are arranged adjacent to each other such that the election-accumulated region 130 and the hole-accumulated region 140 form a pn-junction 150, while the first and second metal layers are electrically separated.

The exemplary semiconductor device 10 of Fig. 1 is configured as a pn-diode, having a pn-junction 150 formed in the semiconductor layer 12. In this embodiment the first metal layer of the first contact 13 and the second metal layer of the second contact 14 are in direct contact with the semiconductor layer 12. Additionally, the semiconductor device 10 comprises an insulating substrate 11 in contact with the semiconductor layer 12 and arranged on the side opposite to the first and second contacts 13, 14 for ease of handling of the semiconductor device 10. Accordingly, the semiconductor device 10 is embodied as an ultrathin silicon-on-insulator wafer, which comprises an intrinsic Si semiconductor layer 12, onto which the first and second contacts 13, 14 are placed.

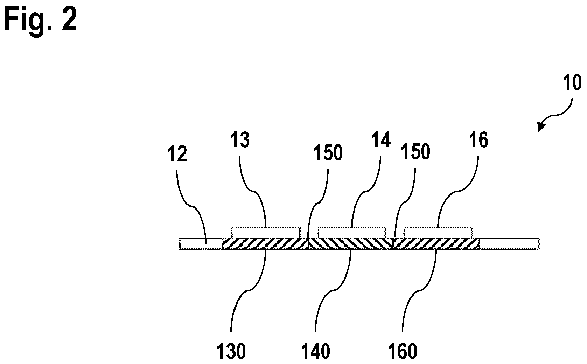

Fig. 2 illustrates a second embodiment of a semiconductor device 10, which comprises a third contact 16 in contact with the semiconductor layer 12, providing the functionality of a npn BJT. The third contact 16 comprises a third metal layer configured to form an Ohmic contact with the semiconductor layer 12 and to provide the third contact 16 for the creation of an electron-accumulated region 160 in the semiconductor layer 12. The third metal layer is electrically separated from the second metal layer as well as from the first metal layer. In its configuration, the third metal layer corresponds to the first metal layer and is accordingly also formed from Ti.

The electron-accumulated region 160 corresponds in its electrical properties to the electron-accumulated region 130 created by the first contact 13. The second and third contacts 14, 16 are arranged adjacent to each other such that the electron-accumulated region 160 and the hole-accumulated region 140 form another pn-junction 150 in the semiconductor layer 12.

The second contact 14, being configured as a base, is arranged between the first contact 13, being configured as an emitter, and the third contact 16, being configured as a collector, for controlling charge flow between emitter and collector, i.e. between first and third contacts 13, 16, by modulating a voltage applied to the second contact 14. The first, second and third contacts 13, 14, 16 are arranged alternately in series on the same side of the semiconductor layer 12, such that the electron-accumulated region 130 of the emitter and the hole-accumulated region 140 of the base forms a pn-junction 150 as well as the electron-accumulated region 160 of the collector and the hole-accumulated region 140 of the base.

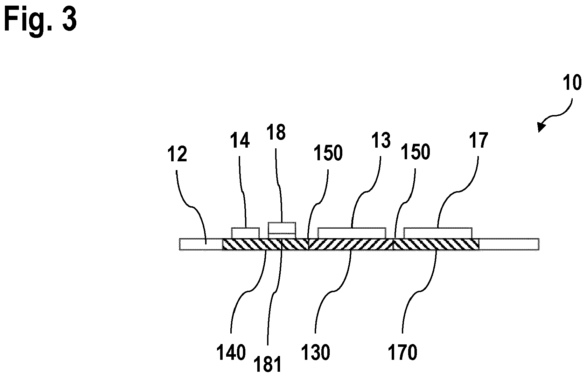

In Fig. 3 a third embodiment of a semiconductor device 10 is shown, which also provides the functionality of a BJT, however of the inverse type, which is a pnp BJT. The exemplary semiconductor device 10 according to this embodiment comprises a third contact 17 with a third metal layer configured to form an Ohmic contact with the semiconductor layer 12 and to provide the third contact 17 for the creation of a hole-accumulated region 170 in the semiconductor layer 12. The third metal layer is electrically separated from the second metal layer as well as from the first metal layer, and corresponds in its configuration to the second metal layer, being also formed from Pd.

The hole-accumulated region 170 corresponds to the hole-accumulated region 140 created by the second contact 14 in its electrical properties. The first and third contacts 13, 17 are arranged adjacent to each other such that the hole-accumulated region 170 and the electron-accumulated region 130 form another pn-junction 150 in the semiconductor layer 12.

In this embodiment, the first contact 13, being configured as a base, is arranged between the second contact 14, being configured as an emitter, and the third contact 17, being configured as a collector, for controlling charge flow between emitter and collector, i.e. between second and third contacts 14, 17 by modulating a voltage applied to the first contact 13. The second, first and third contacts 14, 13, 17 are arranged alternately in series on the same side of the semiconductor layer 12, such that the hole-accumulated region 140 of the emitter and the electron-accumulated region 130 of the base form a pn-junction 150 as well as the hole-accumulated region 170 of the collector and the electron-accumulated region 130 of the base.

In the example of Fig. 3, the semiconductor device 10 additionally comprises a fourth contact 18 arranged between the emitter, i.e. the second contact 14, and the base, i.e. the first contact 13. The fourth contact 18 is electrically separated from the emitter as well as from the base and comprises a metal layer, which corresponds in its configuration to the metal layer of the emitter, i.e. the first or the second metal layer. Accordingly, in the illustrated example, the metal layer of the fourth contact 18 is formed correspondingly to the second metal layer of the second contact 14. An insulating layer 181 is arranged between the semiconductor layer 12 and the metal layer of the first contact 18. For the case of the semiconductor device 10 being in a npn BJT embodiment of Fig. 2, the fourth contact 18 would accordingly comprise a metal layer correspondingly formed to the first metal layer of the first contact 13.

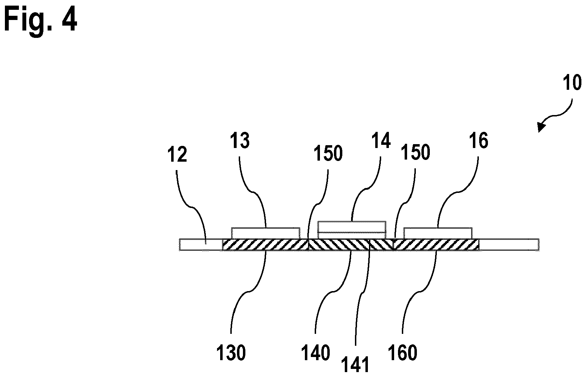

The semiconductor device 10 of the fourth embodiment of Fig. 4 is based on the one of Fig. 2, with the second contact 14 comprising an insulating layer 141 between the second metal layer and the semiconductor layer 12. The first contact 13 is configured as a source, the third contact 16 is configured as a drain, and the second contact 14, being arranged between the first contact 13 and the third contact 16, is configured as a gate for controlling charge flow between source and drain.

The semiconductor device 10 of Fig. 4 provides the functionality of a n-channel MOSFET with an isolated gate connection for controlling the current-voltage characteristics. Charge flow between source and drain can be controlled by modulating a voltage applied to the second contact 14, which acts as the gate.

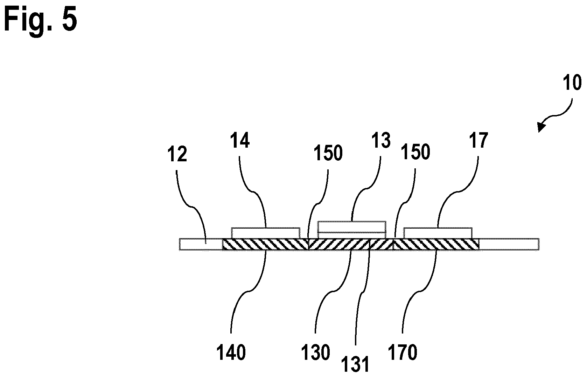

In Fig. 5 a fifth embodiment of a semiconductor device 10 is shown, which also provides the functionality of a MOSFET, however of the inverse type, which is a p-channel MOSFET. The exemplary semiconductor device 10 according to this embodiment comprises a third contact 17 with a third metal layer configured to form an Ohmic contact with the semiconductor layer 12 and to provide the third contact 17 for the creation of a hole-accumulated region 170 in the semiconductor layer 12. The third metal layer is electrically separated from the second metal layer as well as from the first metal layer, and corresponds in its configuration to the second metal layer, being also formed from Pd. The hole-accumulated region 170 corresponds to the hole-accumulated region 140 created by the second contact 14 in its electrical properties. The first and third contacts 13, 17 are arranged adjacent to each other such that the hole-accumulated region 170 and the electron-accumulated region 130 form another pn-junction 150 in the semiconductor layer 12. The first contact 13 comprises an insulating layer 131 between the first metal layer and the semiconductor layer 12. The second contact 14 is configured as a source, the third contact 17 is configured as a drain, and the first contact 13, being arranged between the second contact 14 and the third contact 17, is configured as a gate for controlling charge flow between source and drain.

The semiconductor device 10 of Fig. 5 provides the functionality of a p-channel MOSFET with an isolated gate connection for controlling the current-voltage characteristics. Charge flow between source and drain can be controlled by modulating a voltage applied to the first contact 13, which acts as the gate.

The exemplary dopant-free semiconductor devices 10 described above with reference to Figs. 1-5 are implemented free of further contacts. Accordingly, the semiconductor devices 10 only have those first, second, third and fourth contacts 13, 14, 16, 17, 18 as specifically described in the respective embodiments. No further contacts are required to accomplish proper operation of the semiconductor devices 10 in the specified number. Each of the contacts mentioned above is implemented as a single contact, and in particular not divided into multiple subcontacts fulfilling the same function.

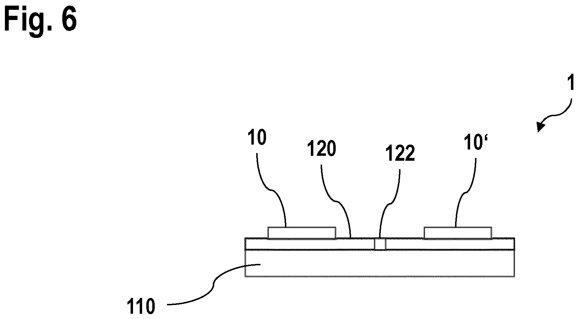

An embodiment of an electric circuit element 1 comprising a first dopant-free semiconductor device 10 and a second dopant-free semiconductor device 10' is presented in Fig. 6. Exemplarily, the first semiconductor device 10 is embodied as the example of Fig. 2, providing the functionality of a npn BJT, and the second semiconductor device 10' is embodied as the example of Fig. 3, providing the functionality of a pnp BJT.

In the electric circuit element 1, the intrinsic semiconductor layers 12 of the first semiconductor device 10 and the second semiconductor device 10' are implemented in the form of a single common semiconductor layer 120. The common semiconductor layer 120 comprises an insulating portion 122, which extends along the entire thickness of the common semiconductor layer 120 and electrically separates the semiconductor layer 12 of the first semiconductor device 10 from the semiconductor layer 12 of the second semiconductor device 10'. Additionally, electric circuit element 1 comprises an insulating layer 100 in contact with the semiconductor layer 120 and arranged on the side opposite to the contacts of the first and second semiconductor devices 10, 10'.

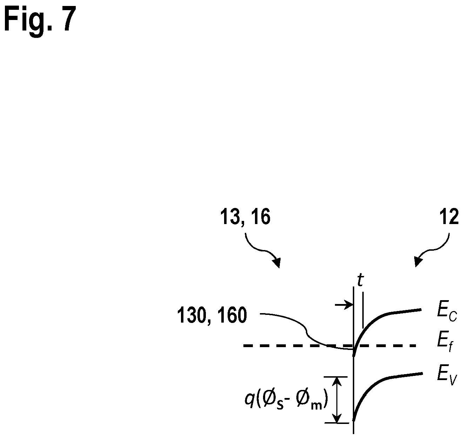

Fig. 7 shows a band diagram of an Ohmic contact formed by contacting the semiconductor layer 12 with the first contact 13 or the third contact 16, and creating the electron-accumulated regions 130, 160 in the semiconductor layer 12. The work function Øₘ of the first metal layer of the first and third contacts 13, 16 is less than the work function Øₛ of the semiconductor of the semiconductor layer 12, such that the edge of the conduction band E_{c} of the semiconductor bends down towards its Fermi level E_{f}, in parallel to the valence band Eᵥ, at the contact area between the semiconductor layer 12 and the respective first and third contacts 13, 16. At this contact area, and from there to a depth t into the semiconductor, the conduction band E_{c} is bent down and electrons can migrate from the first metal layer to the semiconductor layer 12 and create the electron-accumulated region 130, 160, which is located in the semiconductor layer 12 in a region starting from the contact area. The effect of conduction band bending in terms of energy can be obtained by subtracting the work function of the metal Øₘ from the semiconductor work function Øₛ and multiplying with the charge q. In the illustrated example, the effect of conduction band bending is larger than 0.3 eV, wherein in the electron-accumulated region 130, 160, the conduction band E_{c} is below the Fermi level E_{f}.

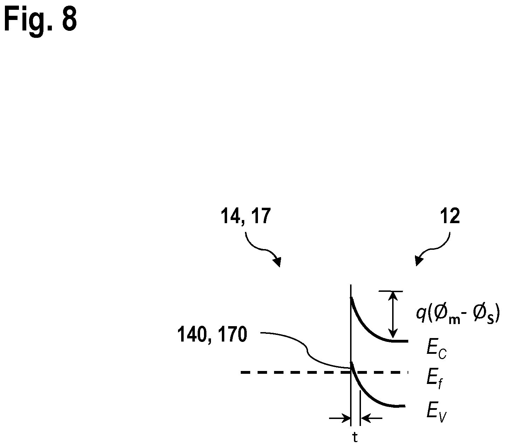

A corresponding band diagram of an Ohmic contact formed by contacting the semiconductor layer 12 with the second contact 14 or the third contact 17, and inversely creating the hole-accumulated regions 140, 170 in the semiconductor layer 12, is presented in Fig. 8. The work function Øₘ of the second metal layer of the second and third contacts 14, 17 is larger than the work function Øₛ of the semiconductor of the semiconductor layer 12, such that the edge of the valence band Eᵥ of the semiconductor bends up towards its Fermi level E_{f}, in parallel to the valence band Eᵥ, at the contact area between the semiconductor layer 12 and the respective second and third contacts 14, 17. At this contact area, and from there to a depth t into the semiconductor, the valence band Eᵥ is bent up. Electrons can migrate from the semiconductor layer 12 to the metal, leaving behind holes, and create the hole-accumulated region 140, 170, which is located in the semiconductor layer 12 in a region starting from the contact area. The effect of valence band bending in terms of energy can be obtained by subtracting the semiconductor work function Øₛ from the work function of the metal Øₘ and multiplying with the charge q. In the illustrated example, the effect of valence band bending is larger than 0.3 eV, wherein in the hole-accumulated region 140, 170, the valence band Eᵥ is above the Fermi level E_{f}.

## Claims

1. Dopant-free semiconductor device (10) comprising:
- an intrinsic semiconductor layer (12),
- a first contact (13) in contact with the semiconductor layer (12), the first contact (13) comprising a first metal layer configured to form an Ohmic contact with the semiconductor layer (12) and to provide the first contact (13) for the creation of an electron-accumulated region (130) in the semiconductor layer (12),
- a second contact (14) in contact with the semiconductor layer (12), the second contact (14) comprising a second metal layer configured to form an Ohmic contact with the semiconductor layer (12) and to provide the second contact (14) for the creation of a hole-accumulated region (140) in the semiconductor layer (12), wherein the first and second contacts are arranged adjacent to each other such that the electron-accumulated region (130) and the hole-accumulated region (140) form a pn-junction (150), and wherein the first metal layer and the second metal layer are electrically separated from each other.

2. Dopant-free semiconductor device (10) according to claim 1, wherein in the electron-accumulated region (130) the conduction band is below the Fermi level, and/or wherein in the hole-accumulated region (140) the valence band is above the Fermi level.

3. Dopant-free semiconductor device (10) according to any one of the preceding claims, wherein the semiconductor layer (12) is at least partially formed from Si, wherein the first metal layer is at least partially formed from Ti or Ag, and/or wherein the second metal layer is at least partially formed from Pd or Ni.

4. Dopant-free semiconductor device (10) according to any one of the preceding claims, wherein the electron-accumulated region (130) and/or the hole-accumulated region (140) is created along the entire thickness of the semiconductor layer (11).

5. Dopant-free semiconductor device (10) according to any one of the preceding claims, further comprising an insulating substrate (11) in contact with the semiconductor layer (12) .

6. Dopant-free semiconductor device (10) according to any one of the preceding claims, further comprising a third contact (16) in contact with the semiconductor layer (12), the third contact (16) comprising a third metal layer configured to form an Ohmic contact with the semiconductor layer (12) and to provide the third contact (16) for the creation of an electron-accumulated region (160) in the semiconductor layer (12), wherein the second and third contacts are arranged adjacent to each other such that the electron-accumulated region (160) created by the third contact (16) and the hole-accumulated region (140) form a pn-junction (150), wherein the third metal layer and the second metal layer are electrically separated from each other, wherein the first contact (13) is configured as an emitter, wherein the second contact (14) is configured as a base, wherein the third contact (16) is configured as a collector, and wherein the second contact (14) is arranged between the first contact (13) and the third contact (16) for controlling charge flow between emitter and collector.

7. Dopant-free semiconductor device (10) according to any one of claims 1 to 5, further comprising a third contact (17) in contact with the semiconductor layer (12), the third contact (17) comprising a third metal layer configured to form an Ohmic contact with the semiconductor layer (12) and to provide the third contact (17) for the creation of a hole-accumulated region (170) in the semiconductor layer (12), wherein the second and third contacts are arranged adjacent to each other such that the hole-accumulated region (170) created by the third contact (17) and the electron-accumulated region (130) form a pn-junction (150), wherein the third metal layer and the first metal layer are electrically separated from each other, wherein the second contact (14) is configured as an emitter, wherein the first contact (13) is configured as a base, wherein the third contact (17) is configured as a collector, and wherein the first contact (13) is arranged between the second contact (14) and the third contact (17) for controlling charge flow between emitter and collector.

8. Dopant-free semiconductor device (10) according to any one of claims 6 to 7, further comprising a fourth contact (18) arranged between the emitter and the base, wherein the fourth contact (18) is electrically separated from the emitter, wherein the fourth contact (18) comprises a metal layer corresponding to the metal layer of the emitter and an insulating layer (181) arranged between the semiconductor layer (12) and the metal layer of the fourth contact (18) .

9. Dopant-free semiconductor device (10) according to any one of claims 1 to 5, further comprising a third contact (16) in contact with the semiconductor layer (12), the third contact (16) comprising a third metal layer configured to form an Ohmic contact with the semiconductor layer (12) and to provide the third contact (16) for the creation of an electron-accumulated region (160) in the semiconductor layer (12), wherein the second and third contacts are arranged adjacent to each other such that the electron-accumulated region (160) created by the third contact and the hole-accumulated region (140) form a pn-junction (150), wherein the third metal layer and the second metal layer are electrically separated from each other, wherein the first contact (13) is configured as a source, wherein the second contact (14) is configured as a gate comprising an insulating layer (141) between the second metal layer and the semiconductor layer (12), wherein the third contact (16) is configured as a drain, and wherein the second contact (14) is arranged between the first contact (13) and the third contact (16) for controlling charge flow between source and drain.

10. Dopant-free semiconductor device (10) according to any one of claims 1 to 5, further comprising a third contact (17) in contact with the semiconductor layer (12), the third contact (17) comprising a third metal layer configured to form an Ohmic contact with the semiconductor layer (12) and to provide the third contact (17) for the creation of a hole-accumulated region (170) in the semiconductor layer (12), wherein the first and third contacts are arranged adjacent to each other such that the hole-accumulated region (170) created by the third contact and the electron-accumulated region (130) form a pn-junction (150), wherein the third metal layer and the first metal layer are electrically separated from each other, wherein the second contact (14) is configured as a source, wherein the first contact (13) is configured as a gate comprising an insulating layer (131) between the first metal layer and the semiconductor layer (12), wherein the third contact (17) is configured as a drain, and wherein the first contact (13) is arranged between the second contact (14) and the third contact (17) for controlling charge flow between source and drain.

11. Dopant-free semiconductor device (10) according to any one of claims 9 to 10, wherein gate and drain are separated from each other by a distance, which is larger than the thickness of the insulating layer (131, 141).

12. Dopant-free semiconductor device (10) according to any one of the preceding claims, wherein the semiconductor device (10) is free of further contacts.

13. Method of manufacturing a dopant-free semiconductor device (10) according to any one of the preceding claims, comprising:
- providing an intrinsic semiconductor layer (12);
- providing a first contact (13) onto the semiconductor layer (12) comprising applying a first metal layer configured to form an Ohmic contact with the semiconductor layer (12) and to provide the first contact (13) for the creation of an electron-accumulated region (130) in the semiconductor layer (12); and
- providing a second contact (14) onto the semiconductor layer (12), comprising applying a second metal layer electrically separated from the first metal layer, configured to form an Ohmic contact with the semiconductor layer (12) and to provide the second contact (14) for the creation of a hole-accumulated region (140) in the semiconductor layer (12), wherein the first and second contacts are arranged adjacent to each other such that the electron-accumulated region (130) and the hole-accumulated region (140) form a pn-junction (140).

14. Electrical circuit element (1) comprising a first dopant-free semiconductor device (10) according to any one of the preceding claims and a second dopant-free semiconductor device (10') according to any one of the preceding claims, wherein the semiconductor layers of the first and second dopant-free semiconductor devices are formed of a single common semiconductor layer (120), and wherein preferably the common semiconductor layer (120) comprises an insulating portion (122) extending along the entire thickness of the common semiconductor layer (120) for electrically separating the semiconductor layer of the first dopant-free semiconductor device (10) from the semiconductor layer of the second dopant-free semiconductor device (10').

15. Electrical circuit element (1) according to claim 14,
wherein the first dopant-free semiconductor device (10) is embodied according to claim 6 and the second dopant-free semiconductor device (10') is embodied according to claim 7 or wherein the first dopant-free semiconductor device (10) is embodied according to claim 9 and the second dopant-free semiconductor device (10') is embodied according to claim 10.
